(19) Europäisches Patentamt
European Patent Office
Office européen des brevets

(11) **EP 4 708 112 A1**

(12) **EUROPEAN PATENT APPLICATION**

(43) Date of publication:
**11.03.2026 Bulletin 2026/11**

(21) Application number: **25199677.3**

(22) Date of filing: **02.09.2025**

(51) International Patent Classification (IPC):
**G06F 30/20** (2020.01)    **G06F 30/27** (2020.01)
**G06N 20/00** (2019.01)    **G06Q 10/04** (2023.01)

(52) Cooperative Patent Classification (CPC):
**G06F 30/20; G06F 30/27; G06N 20/00;
G06Q 10/04;** G06F 2207/4824

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **02.09.2024 IN 202411066190**

(71) Applicant: Honeywell International Inc.
**Charlotte, NC 28202 (US)**

(72) Inventors:
• **RENFRO, Jeffrey G.**
  **Charlotte, 28202 (US)**
• **DEVARAJAN, Ashalatha**
  **Charlotte, 28202 (US)**
• **ARUNACHALAM, Soundari**
  **Charlotte, 28202 (US)**
• **PALANISAMY, Lingathurai**
  **Charlotte, 28202 (US)**

(74) Representative: **Houghton, Mark Phillip
Patent Outsourcing Limited
1 King Street
Bakewell, Derbyshire DE45 1DZ (GB)**

(54) **SYSTEMS AND METHODS FOR OPTIMIZING RENEWABLE ENERGY SITE SELECTION FOR HYDROGEN PRODUCTION USING SURROGATE MODELING**

(57)    Embodiments of the present disclosure provide optimal site selection framework. A surrogate process model may be generated based on one or more physics-informed machine learning models and a rigorous dynamic process model. The surrogate process model may comprise a representation of a process including one or more target assets and one or more secondary assets. The process input for the one or more target assets may comprise power output from a renewable energy source. A design optimization algorithm representative of a multi-objective design optimization problem may be generated. The design optimization algorithm may comprise one or more site selection variables and one or more site selection constraints. One or more outputs may be generated by executing an optimization model based on the surrogate process model and the design optimization algorithm. The one or more outputs may comprise predicted optimal sites and an optimal conceptual design for the process.

```
          ( START )  ⟋ 300
              │
              ▼
   GENERATE SURROGATE MODEL            ── 302
              │
              ▼
   GENERATE REPRESENTATIVE POWER PROFILE INPUT DATA   ── 304
              │
              ▼
   AGGREGATE DATA ASSOCIATED WITH THE TARGET
   ASSET AND OPTIONAL EQUIPMENT         ── 306
              │
              ▼
   GENERATE AN OPTIMIZATION MODEL       ── 308
              │
              ▼
   EXECUTE THE OPTIMIZATION MODEL TO GENERATE
   OPTIMAL CONCEPTUAL DESIGN            ── 310
              │
              ▼
   INITIATE PERFORMANCE OF ONE OR MORE
   PREDICTION BASED ACTIONS             ── 312
              │
              ▼
          ( END )
```

**FIG. 3**

EP 4 708 112 A1

**Description**

TECHNOLOGICAL FIELD

Embodiments of the present disclosure generally relate to process design. An Example embodiment relates to a generating optimal conceptual design for a hydrogen production process (or other processes) and optimal renewable energy plant site selection.

BACKGROUND

Various embodiments of the present disclosure address technical challenges related to process design. Through applied effort, ingenuity, and innovation, Applicant has solved problems related to process design by developing solutions embodied in the present disclosure, which are described in detail below.

BRIEF SUMMARY

In accordance with one aspect of the present disclosure, a computer-implemented method for generating optimal site selection is provided. The computer-implemented method is executable using any of a myriad of computing device(s) and/or combinations of hardware, software, and/or firmware. In some example embodiments, an example computer-implemented method includes generating, by one or more processors and based on one or more physics-informed machine learning models and a rigorous dynamic process model, a surrogate process model, wherein the surrogate process model comprises a representation of a process including one or more target assets and one or more secondary assets, wherein process input for the one or more target assets comprises power output from a renewable energy source; generating, using the one or more processors, a design optimization algorithm representative of a multi-objective design optimization problem, wherein the design optimization algorithm comprises one or more site selection variables and one or more site selection constraints; generating, by the one or more processors, one or more outputs by executing an optimization model based on the surrogate process model and the design optimization algorithm, wherein the one or more outputs comprise predicted optimal sites and an optimal conceptual design for the process; and initiating, using the one or more processors, performance of one or more prediction-based actions based at least in part on the optimal conceptual design.

In some embodiments, generating the design optimization algorithm comprises representing the site selection variable in the design optimization algorithm as a binary variable, and wherein the one or more site selection constraints comprises a constraint that enforces a sum of the one or more site selection variables to equal one.

In some embodiments, the computer-implemented method further includes aggregating data associated with one or more candidate renewable energy sites.

In some embodiments, input data for the design optimization problem comprises at least location data for each of the one or more candidate renewable energy sites.

In some embodiments, the one or more candidate renewable energy sites comprise one or more of a solar power plant or a wind power plant.

In some embodiments, generating the surrogate process model comprises generating one or more dynamic process simulation case runs based on the rigorous dynamic process model and design of experiments; executing the one or more dynamic process simulation case runs to generate simulation data; and generating a surrogate flowsheet model corresponding to the surrogate process model by applying the physics-informed machine learning model to the simulation data.

In some embodiments, the process is a hydrogen production process configured for producing green hydrogen, the one or more target assets comprise one or more electrolyzers, and the one or more secondary assets comprise one or more power storage devices and one or more storage tanks, wherein the one or more power storage devices and the one or more storage tanks are configured for building a buffer to mitigate against effect of intermittent power supply from the renewable energy source.

In some embodiments, the optimal conceptual design comprises one or more of (i) optimal number of electrolyzers, (ii) optimal number of power storage devices, or (iii) optimal number of hydrogen storage tanks.

In some embodiments, initiating the performance of the one or more prediction based actions comprises causing rendering of a user interface comprising the predicted optimal sites and the optimal conceptual design.

In accordance with another aspect of the present disclosure, an apparatus for asset performance predictions is provided. The apparatus in some embodiments includes at least one processor and at least one non-transitory memory, the at least one non-transitory memory having computer-coded instructions stored thereon. The computer-coded instructions in execution with the at least one processor causes the apparatus to perform any of the example computer-implemented methods described herein. In some other embodiments, the apparatus includes means for performing each step of any of the computer-implemented methods described herein.

In accordance with another aspect of the present disclosure, a computer program product for asset performance predictions is provided. The computer program product in some embodiments includes at least one non-transitory computer-readable storage medium having computer program code stored thereon. The computer program code in execution with at least one processor is configured for performing any one or the example computer-implemented methods described herein.

BRIEF DESCRIPTION OF THE DRAWINGS

Having thus described the embodiments of the disclosure in general terms, reference now will be made to the accompanying drawings, which are not necessarily drawn to scale, and wherein:

FIG. 1 illustrates a block diagram of a system that may be specially configured within which embodiments of the present disclosure may operate.
FIG. 2 illustrates a block diagram of an example apparatus that may be specially configured in accordance with an example embodiment of the present disclosure.
FIG. 3 illustrates a flowchart including example operations of an example process for generating optimal conceptual design in accordance with at least one example embodiment of the present disclosure.
FIG. 4 illustrates a flowchart including example operations of an example process for generating a surrogate process model in accordance with at least one example embodiment of the present disclosure.
FIG. 5 illustrates a flowchart including example operations of an example process for optimal site selection in accordance with at least on example embodiment of the present disclosure.
FIG. 6 illustrates an example base flowsheet model in accordance with at least on example embodiment of the present disclosure.
FIG. 7 illustrates example interactions between example applications and models associated with generating optimal conceptual design and optimal site selection in accordance with at least on example embodiment of the present disclosure.

DETAILED DESCRIPTION

Embodiments of the present disclosure now will be described more fully hereinafter with reference to the accompanying drawings, in which some, but not all, embodiments of the disclosure are shown. Indeed, embodiments of the present disclosure may be embodied in many different forms and should not be construed as limited to the embodiments set forth herein, rather, these embodiments are provided so that this disclosure will satisfy applicable legal requirements. The term "or" is used herein in both the alternative and conjunctive sense, unless otherwise indicated. The terms "illustrative" and "example" are used to be examples with no indication of quality level. Terms such as "computing," "determining," "generating," and/or similar words are used herein interchangeably to refer to the creation, modification, or identification of data. Further, "based on," "based on in part on," "based at least on," "based upon," and/or similar words are used herein interchangeably in an open-ended manner such that they do not indicate being based only on or based solely on the referenced element or elements unless so indicated. Like numbers refer to like elements throughout.

Overview and Technical Improvements

Various embodiments of the present disclosure address technical challenges related to process design. Corporations are seeking to reduce carbon emissions to meet Net Zero emissions objectives. One way to reduce emissions for processes that require hydrogen is to switch to using green hydrogen, which has a low carbon intensity. Hence, many corporations and engineering firms are planning to design, build and operate green hydrogen production processes and some require large production rates of hydrogen. Designing a large scale plant to produce green hydrogen is a very complex task. During design, the focus is on creating a blueprint for a plant that meets requisite safety standards, while producing hydrogen at a minimal levelized cost of hydrogen (LCOH). A key factor to be considered in the design is the ability of the plant to operate stably and efficiently in the face of intermittent and dynamic renewable energy profiles. The design process must also seek to avoid rapid turndown, standby or idling modes of electrolyzers under low power conditions that not only negatively impact the electrolyzer life but also reduce the utilization factor of the whole plant.

Intermittent and/or unsteady power supply from renewable energy sources/plants pose substantial challenges to industrial plants that rely on such renewable energy sources, including achieving net zero emission or other sustainability goals. Green hydrogen production, for example, may require a system of electrolyzer modules that consume power to produce hydrogen from water. Further, green hydrogen production may require using renewable energy sources such as wind power plants or solar power plants to certify its "green" status. However, the power output from solar power plants and wind power plants are generally intermittent and unsteady (e.g., solar power plants may not output power during overnight hours and wind power plants may not output power when the wind velocity is about zero or otherwise low). These intermittent and unsteady power supply to the electrolyzers, in turn, result in intermittent and unsteady production of hydrogen.

Moreover, determining the number of electrolyzers and sizes (e.g., power ratings) required to meet hydrogen production target can be challenging. For example, oversizing or having too many electrolyzers may result in excessive cost impact. Further, under sizing or having too few electrolyzers may result in inability to meet hydrogen demand or inability to deliver a stable target rate of hydrogen consistently. Further, determining the optimal location for renewable energy sites from available sites can also be challenging. Solar and wind power profiles, for example, may be different at different geographic locations and may be associated with disparate cost impacts and/or levelized cost of hydrogen (LCOH) impact.

Considering all of these factors, such as intermittent power, the need for flexibility, criticality of producing at minimal LCOH to compete with other hydrogen sources, a need for a new approach to process design exists. Most design problems are solved with a steady state process model. The green hydrogen process may be continuously operating in a transient state, so a dynamic model is required for process design. Also, most traditional process design problems would not weigh heavily for startup and shutdown costs since these events are not frequent. The green hydrogen production process may have electrolyzers that start up and shutdown daily and hence this may necessitate the solution of mixed integer optimization to simulate and optimize the operation.

The optimization problem may be a multi-period optimization problem with a long time horizon (e.g., 20 to 30 years). Further, given that the design problem may involve the optimal selection of numbers and sizes of batteries and tanks, and inventory must be managed in the assets, the time period for this design problem may need to be at most an hour. This creates a huge multi-period mixed integer dynamic optimization problem. Because of the computational complexity, commercial dynamic simulation systems cannot be used in this dynamic optimization problem.

Embodiments of the present disclosure utilize a surrogate process model derived from a rigorous dynamic process model using a physics-informed machine learning (PIML) approach. Further, embodiments of the present disclosure condense the problem from a 20-30 year plant lifetime horizon with hourly time periods to a one year "8760" problem (e.g., 8760 hours in a year) By condensing to 8760 problem, example embodiments allow for efficient equipment selection.

Example embodiments, of the present disclosure provide various techniques configured to solve the above challenges, including multi-objective design optimization algorithms representative of a design optimization problem, data compression techniques to solve the long term optimization problem by aggregating power profiles and generating representative power in a computationally efficient manner, integration of PIML-based machine learning surrogate model with an optimizer that enables accurate solutions to be generated, optimization framework that takes into consideration electrolyzer degradation and its effect on remaining useful life, optimization framework that takes into consideration optimal site location with optimal conceptual design by including site choices and incorporating a solar model that predicts irradiance as a function of longitude, latitude and other solar power plant configuration parameters, optimization framework configured capable of producing optimal design of a combination of electrolyzer sizes and types (Alkaline, PEM, and/or the like).

Accordingly, example embodiments of the present disclosure provide various technical advantages including enabling a process design with lower LCOH than cannot be achieved by a manual design approach considering that the design problem is too complex to get an accurate solution via manual case studies. Further, generating a design optimization problem that is mixed integer dynamic optimization approach enables cost impact savings (e.g., including for example, capital and operating cost savings). Further, example embodiments provide various technical advantages by enabling solution of an "8760" optimization problem that is an accurate representation of the 20-30 year plant lifetime horizon; allowing for efficient "what if" case studies for parameters not considered in optimization; providing for generating process design that meets hydrogen demand with minimal LCOH and simultaneously with renewable power location; generating a multi-objective design problem that ensures hydrogen demand is optimally met while simultaneously minimizing LCOH; and utilizing hierarchical optimization formulation from nonlinear model predictive control algorithms to properly address various objectives. Further, by formulating a design problem that includes a site-selection decision variable where the site location can be simultaneously optimized with conceptual process design, example embodiments, allows for the optimizer/optimization model to adjust equipment selection to fit in site area constraints to take advantage of efficient solar and/or wind power plant sites. This allows more sites to be considered globally than could be productively investigated by a manual workflow.

Definitions

Many modifications and other embodiments of the disclosure set forth herein will come to mind to one skilled in the art to which this disclosure pertains having the benefit of the teachings presented in the foregoing description and the associated drawings. Therefore, it is to be understood that the embodiments are not to be limited to the specific embodiments disclosed and that modifications and other embodiments are intended to be included within the scope of the appended claims. Moreover, although the foregoing descriptions and the associated drawings describe example embodiments in the context of certain example combinations of elements and/or functions, it should be appreciated that different combinations of elements and/or functions may be provided by alternative embodiments without departing from the scope of the appended claims. In this regard, for example, different combinations of elements and/or functions than those explicitly described above are also contemplated as may be set forth in some of the appended claims. Although specific terms are employed herein, they are used in a generic and descriptive sense only and not for purposes of limitation.

As used herein, the term "comprising" means including but not limited to and should be interpreted in the manner it is typically used in the patent context. Use of broader terms such as comprises, includes, and having should be understood to provide support for narrower terms such as consisting of, consisting essentially of, and comprised substantially of.

The phrases "in one embodiment," "according to one embodiment," "in some embodiments," and the like generally mean that the particular feature, structure, or characteristic following the phrase may be included in at least one embodiment of the present disclosure and may be included in more than one embodiment of the present disclosure (importantly, such phrases do not necessarily refer to the same embodiment).

The word "example" or "exemplary" is used herein to mean "serving as an example, instance, or illustration." Any implementation described herein as "exemplary" is not necessarily to be construed as preferred or advantageous over other implementations.

If the specification states a component or feature "may," "can," "could," "should," "would," "preferably," "possibly," "typically," "optionally," "for example," "often," or "might" (or other such language) be included or have a characteristic, that a specific component or feature is not required to be included or to have the characteristic. Such a component or feature may be optionally included in some embodiments, or it may be excluded.

The term "industrial plant," "plant," and/or similar terms used herein interchangeably may refer to one or more buildings, complex, or arrangement of components that perform a chemical, physical, electrical, mechanical process, and/or the like for converting input materials into one or more output products. Non-limiting examples of an industrial plant include a chemical industrial plant, automotive manufacturing plant, distillery, oil refinery, fabric manufacturing plant, and/or the like.

The term "physical component" with respect to an industrial plant may refer to a realworld machine, system, or other physical structure within and/or associated with the industrial plant, and that is utilized by the industrial plant. For example, a physical component with respect to an industrial plant may comprise a machine, system, or other structure that is utilized in a process performed by the industrial plant. In an example context of an oil refinery plant, non-limiting examples of a physical component may include a furnace, a pump, a heat exchanger, and/or the like.

The term "optimization model" refers to any statistical, algorithmic, mathematical, and/or machine learning data construct(s) configured to process various input data, configuration inputs, hard constraints, soft constraints, optimization parameters, uncertainty models, and/or other data, or any combination thereof, pertinent to the formulation of an optimization model (e.g., design optimization problem thereof) and constructed in a format such that an optimization system may generate an optimized conceptual design for a process (such as, for example, hydrogen production process) relative to one or more optimization parameters utilizing the data construct(s).

In some embodiments, the optimization model is embodied by or includes a mathematical model, such as a system of equations that may be generated based on the selected optimization parameters, configuration input data, hard constraints, soft constraints, and/or the like. In some embodiments, an optimization model includes one or more models or incorporates one or more models. In some embodiments, an optimization model comprises one or more optimization problems such design optimization problems. In some embodiments, such design optimization problems may be represented as an optimization algorithm.

As used herein, the term "renewable energy source" refers to a source that will easily replenish over time and the term "non-renewable energy source" means a source that will not be easily replenished over time. For example, a renewable energy source can include renewable electricity sources, such as solar energy, hydropower energy, wind energy, and renewable fuel sources, such as green hydrogen fuel and biofuels. A non-renewable energy source can include non-renewable electricity sources, such as coal power, and non-renewable fuel sources, such as petroleum or gray hydrogen fuel.

The term "industrial plant," "plant," "processing plant," "process plant," and/or similar terms used herein interchangeably may refer to a building, complex, or arrangement of components that perform a chemical, physical, electrical, mechanical process, and/or the like for converting input materials into one or more output products. Non-limiting examples of an industrial plant include a chemical industrial plant, automotive manufacturing plant, distillery, oil refinery, fabric manufacturing plant, and/or the like. In some embodiments, a plant includes any number of assets embodying physical components that enable performance of a plant process.

The terms "optimization parameter," "input data", and "variables" may be any element, feature, factor, or other variable aspect of an asset, plurality of assets, or the surrounding operational environment, that may be input in a model such as an optimization model.

The terms "optimal conceptual design," refers to an output of an optimization model (e.g., design optimization model) An optimal conceptual design can include data for one or more secondary asset (e.g., number of secondary power source, and corresponding sizes and types, number of process output storage tanks and corresponding types and sizes), and/or the like.

The term "product", "process output", and/or similar terms used interchangeably may refers to an object or other physical combination of multiple input. A non-limiting example of a product includes green hydrogen. It should be appreciated that different products include different properties and/or characteristics.

The term "time horizon" may refer to electronically managed data representing a length of time (e.g., time interval).

The term "time interval" refers to a range of time defined by two or more timestamps.

The term "dynamic model," "dynamic process model," or similar term may refer to any statistical, algorithmic, mathematical, and/or machine learning data construct(s) configured to process various input data, to generate an output. A dynamic model may include calculation models to calculate at least one of a status of the processing equipment or the plant process or to calculate efficiency of the equipment of plant process or to calculate the state and physical properties of the fluid associated with the equipment, symptom and fault models to determine a health of the processing equipment plant process including cause and effect logic, dynamic simulation of the processing equipment or the plant process to predict future performance or compare current (e.g., real time) performance against simulation, and machine learning models to detect changes in the processing equipment or performance of the plant process based on data analysis.

The term "flowsheet model" refers to renderable format for representing physical component(s), connection(s) between said physical component(s), and/or flow of inputs and/or products between such physical component(s), utilizing one or more graph element(s). A flowsheet model may refer to a model that describes the process flow through a plant. In some embodiments, a flowsheet model may comprise a collection of virtual process model objects as a unit of process design. In some embodiments, each element of a flowsheet model may correspond to particular physical component and/or virtual component of a process plant. A flowsheet model, for example, may depict a physical layout and configuration of a particular processing plant, and/or a virtualized abstraction of physical component(s) of a process plant. Additionally, a flowsheet model may define connections between the components. In this regard, input products may flow between such components based at least in part on such connections, for example, for use in production one or more products within the processing plant represented by the model.

.The term "digital twin" may refer to a digital model of a processing plant, including physical components, that supports at least simulation.

EXAMPLE SYSTEMS AND APPARATUSES OF THE DISCLOSURE

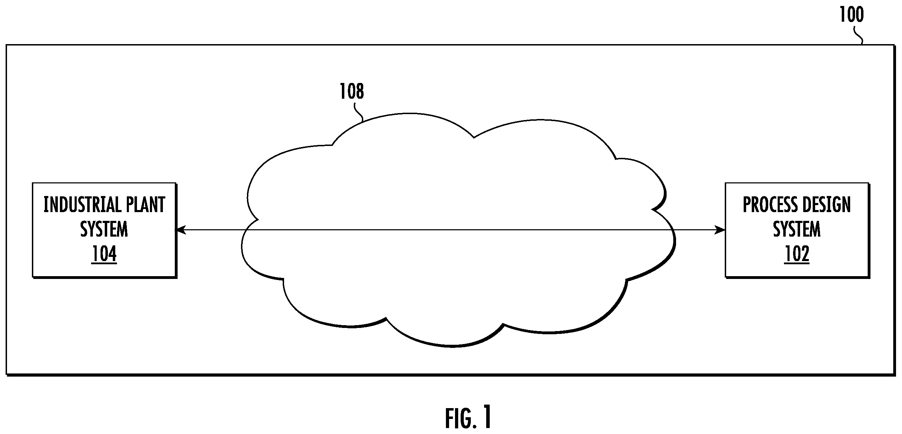

FIG. 1 illustrates a block diagram of a system that may be specially configured within which embodiments of the present disclosure may operate. Specifically, FIG. 1 depicts an example system 100. As illustrated, the system 100 includes an industrial plant system 104, in communication with a process design system 102. In some embodiments, the industrial plant system 104 communicates with the process design system 102 over one or more communication network(s), for example a communication network 108. In some embodiments, the process design system 102 is in communication with a plurality of industrial plant systems, each identically or similarly configured to the industrial plant system 104. In some such embodiments, the process design system 102 may process data associated with each industrial plant system independently, and/or in some contexts processes data associated with multiple industrial plant systems in the aggregate (e.g., when processing all industrial plant systems associated with a particular entity, region, and/or the like).

It should be appreciated that the communications network 108 in some embodiments is embodied in any of a myriad of network configurations. In some embodiments, the communications network 108 embodies a public network (e.g., the Internet). In some embodiments, the communications network 108 embodies a private network (e.g., an internal localized, or closed-off network between particular devices). In some other embodiments, the communications network 108 embodies a hybrid network (e.g., a network enabling internal communications between particular connected devices and external communications with other devices). The communications network 108 in some embodiments includes one or more base station(s), relay(s), router(s), switch(es), cell tower(s), communications cable(s) and/or associated routing station(s), and/or the like. In some embodiments, the communications network 108 includes one or more user controlled computing device(s) (e.g., a user owned router and/or modem) and/or one or more external utility devices (e.g., Internet service provider communication tower(s) and/or other device(s)).

Each of the components of the system 100 communicatively coupled to transmit data to and/or receive data from one another over the same or different wireless and/or wired networks embodying the communications network 108. Such configuration(s) include, without limitation, a wired or wireless Personal Area Network (PAN), Local Area Network (LAN), Metropolitan Area Network (MAN), Wide Area Network (WAN), and/or the like. Additionally, while FIG. 1 illustrate certain system entities as separate, standalone entities communicating over the communications network 108, the various embodiments are not limited to this architecture. In other embodiments, one or more computing entities share one or more components, hardware, and/or the like, or otherwise are embodied by a single computing device such that connection(s) between the computing entities are over the communications network 108 are altered and/or rendered unnecessary. For example, in some embodiments, the industrial plant system 104 includes some or all of the process design system 102, such that an external communications network 108 is not required.

In some embodiments, the industrial plant system 104 and the process design system 102 are embodied in an on-premises system within or associated with the industrial plant. In some such embodiments, the industrial plant system 104 and the process design system 102 are communicatively coupled via at least one wired connection. Alternatively, or additionally, in some embodiments, the industrial plant system 104 embodies or includes the process design system 102, for example as a software component of a single enterprise terminal.

The industrial plant system 104 includes any number of computing device(s), system(s), physical component(s), and/or the like, that facilitates producing of any number of products, for example utilizing particular configurations that cause processing of particular inputs available within the industrial plant system 104. In some embodiments, the industrial plant system 104 includes one or more physical component(s), connection(s) between physical component(s), and/or computing system(s) that control operation of each physical component therein. The industrial plant system 104, for example, can embody a green hydrogen production plant, an oil refinery, an automotive engine manufacturing plant, a distillery, and/or the like, which includes physical component(s) that perform particular process(es) to alter properties of inputs to the component(s). Additionally, or alternatively, in some embodiments the industrial plant system 104 includes one or more computing system(s) that are specially configured to operate the physical component(s) in a manner that produces one or more particular product(s) simultaneously. In some embodiments, an industrial plant system 104 includes one or more computing device(s) and/or system(s) embodied in hardware, software, firmware, and/or a combination thereof, that configure and/or otherwise control operation of one or more physical component(s) in the corresponding industrial plant(s). For example, in some embodiments, such computing device(s) and/or system(s) include one or more programmable logic controller(s), model predictive control(s) (MPC(s)), application server(s), centralized control system(s), and/or the like, that control(s) configuration and/or operation of at least one physical component. It will be appreciated that different industrial plant system(s) may include or otherwise be associated with different physical component(s), computing system(s), and/or the like.

The process design system 102 includes one or more computing device(s) and/or system(s) embodied in hardware, software, firmware, and/or a combination thereof, configured to generate optimal conceptual design associated with operation of one or more industrial plants or particular sub-components thereof. Alternatively, or additionally, the process design system 102 includes one or more computing device(s) and/or system(s) embodied in hardware, software, firmware, and/or a combination thereof, configured for generating an output comprising optimal renewable energy plant sites with respect to a plant process as well as optimal conceptual design for the plant process. In some embodiments, the process design system 102 includes or is associated with a process simulation and modeling application or system such as Honeywell's UniSim Design process simulation software/application. The optimal conceptual design may comprise optimized design data, for example, associated with one or more physical components, assets, and/or the like associated with the one or more industrial plants. The optimal conceptual design, for example, may comprise design data configured to achieve net zero emission within a specified time horizon. In some embodiments, the process design system 102 generates optimal conceptual design for an industrial plant utilizing one or more models, such as physics-informed machine learning model(s), optimization model(s) (which may embody a model predictive control (e.g., a non-linear model predictive control (NMPC)). In some embodiments, the process design system 102, utilizing a physics-informed machine learning (PIML) model and an optimization model, may be configured to formulate and/or optimize one or more design problems, such as green hydrogen design problem associated with the optimization model in order to generate an optimal conceptual design and/or select optimal site location. The optimal conceptual design may be configured to effectively account for at least intermittent and unsteady power supply. The process design system 102, for example, may perform one or more modeling operations that facilitates prediction of an optimal conceptual design associated with the operation of one or more industrial plants, such as a hydrogen production plant, based at least in part on input data associated with the one or more industrial plants and that are input into, applied to, and/or the like to the optimization model.

In some embodiments, the process design system 102 includes one or more application server(s) and/or database server(s) that provide such functionality. Additionally, or alternatively, in some embodiments, the process design system 102 includes or is associated with one or more client device(s), user device(s), and/or the like, that enable access to the functionality provided via the process design system 102, for example via a web application, a native application, and/or the like executed on the client device.

Additionally, or alternatively, in some embodiments, the process design system 102 may be utilized to facilitate control and/or automatic reconfiguration of the operation of one or more physical component(s) in one or more industrial plants. In some embodiments, the process design system 102 includes or embodies a display or other user interface to which a user-facing interface is renderable.

In some embodiments, the process design system 102 and/or industrial plant system 104 communicate with one another to perform the various actions described herein. For example, in some embodiments, the process design system 102 and the industrial plant system 104 communicate to generate optimal conceptual design(s) for a process and/or predict optimal site locations. Additionally, or alternatively, in some embodiments, the process design system 102 and the industrial plant system 104 communicate to facilitate control or adjustment of operation of physical component(s) in the one or more industrial plants based at least in part on the generated optimal conceptual design and/or predicted optimal site location. For example, in some embodiments the process design system 102 and the industrial plant system 104 may communicate to automatically configure or reconfigure one or more physical component(s) of the one or more industrial plants in accordance with the optimal conceptual design and/or predicted optimal site location.

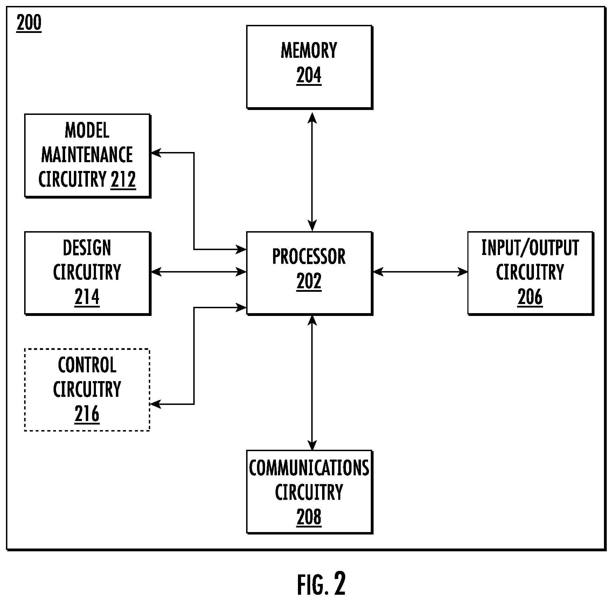

FIG. 2 illustrates a block diagram of an example apparatus that may be specially configured in accordance with an example embodiment of the present disclosure. Specifically, FIG. 2 depicts an example computing apparatus 200 ("apparatus 200") specially configured in accordance with at least some example embodiments of the present disclosure. In some embodiments, the process design system 102, and/or a portion thereof is embodied by one or more system(s), such as the apparatus 200 as depicted and described in FIG. 2. The apparatus 200 includes processor 202, memory 204, input/output circuitry 206, communications circuitry 208, model maintenance circuitry 212, design circuitry 214, and optional control circuitry 216. In some embodiments, the apparatus 200 is configured, using one or more of the sets of circuitry 202, 204, 206, 208, 212, 214, and/or 216, to execute and perform the operations described herein.

In general, the terms computing entity (or "entity" in reference other than to a user), device, system, and/or similar words used herein interchangeably may refer to, for example, one or more computers, computing entities, desktop computers, mobile phones, tablets, phablets, notebooks, laptops, distributed systems, items/devices, terminals, servers or server networks, blades, gateways, switches, processing devices, processing entities, set-top boxes, relays, routers, network access points, base stations, the like, and/or any combination of devices or entities adapted to perform the functions, operations, and/or processes described herein. Such functions, operations, and/or processes may include, for example, transmitting, receiving, operating on, processing, displaying, storing, determining, creating/generating, monitoring, evaluating, comparing, and/or similar terms used herein interchangeably. In one embodiment, these functions, operations, and/or processes can be performed on data, content, information, and/or similar terms used herein interchangeably. In this regard, the apparatus 200 embodies a particular, specially configured computing entity transformed to enable the specific operations described herein and provide the specific advantages associated therewith, as described herein.

Although components are described with respect to functional limitations, it should be understood that the particular implementations necessarily include the use of particular computing hardware. It should also be understood that in some embodiments certain of the components described herein include similar or common hardware. For example, in some embodiments two sets of circuitry both leverage use of the same processor(s), network interface(s), storage medium(s), and/or the like, to perform their associated functions, such that duplicate hardware is not required for each set of circuitry. The use of the term "circuitry" as used herein with respect to components of the apparatuses described herein should therefore be understood to include particular hardware configured to perform the functions associated with the particular circuitry as described herein.

Particularly, the term "circuitry" should be understood broadly to include hardware and, in some embodiments, software for configuring the hardware. For example, in some embodiments, "circuitry" includes processing circuitry, storage media, network interfaces, input/output devices, and/or the like. Alternatively, or additionally, in some embodiments, other elements of the apparatus 200 provide or supplement the functionality of another particular set of circuitry. For example, the processor 202 in some embodiments provides processing functionality to any of the sets of circuitry, the memory 204 provides storage functionality to any of the sets of circuitry, the communications circuitry 208 provides network interface functionality to any of the sets of circuitry, and/or the like.

In some embodiments, the processor 202 (and/or co-processor or any other processing circuitry assisting or otherwise associated with the processor) is/are in communication with the memory 204 via a bus for passing information among components of the apparatus 200. In some embodiments, for example, the memory 204 is non-transitory and may include, for example, one or more volatile and/or non-volatile memories. In other words, for example, the memory 204 in some embodiments includes or embodies an electronic storage device (e.g., a computer readable storage medium). In some embodiments, the memory 204 is configured to store information, data, content, applications, instructions, or the like, for enabling the apparatus 200 to carry out various functions in accordance with example embodiments of the present disclosure.

The processor 202 may be embodied in a number of different ways. For example, in some example embodiments, the processor 202 includes one or more processing devices configured to perform independently. Additionally, or alternatively, in some embodiments, the processor 202 includes one or more processor(s) configured in tandem via a bus to enable independent execution of instructions, pipelining, and/or multithreading. The use of the terms "processor" and "processing circuitry" should be understood to include a single core processor, a multi-core processor, multiple processors internal to the apparatus 200, and/or one or more remote or "cloud" processor(s) external to the apparatus 200.

In an example embodiment, the processor 202 is configured to execute instructions stored in the memory 204 or otherwise accessible to the processor. Alternatively, or additionally, the processor 202 in some embodiments is configured to execute hard-coded functionality. As such, whether configured by hardware or software methods, or by a combination thereof, the processor 202 represents an entity (e.g., physically embodied in circuitry) capable of performing operations according to an embodiment of the present disclosure while configured accordingly. Alternatively, or additionally, as another example in some example embodiments, when the processor 202 is embodied as an executor of software instructions, the instructions specifically configure the processor 202 to perform the algorithms embodied in the specific operations described herein when such instructions are executed.

As one particular example embodiment, the processor 202 is configured to perform various operations associated with generating optimal conceptual design(s) using at least one specially configured model (e.g., optimization model). In some embodiments, the processor 202 includes hardware, software, firmware, and/or a combination thereof, that determines results for one or more problem formulations associated with the specially configured model. In some embodiments, the processor 202 includes hardware, software, firmware, and/or a combination thereof, that generates optimal conceptual design (comprising optimized plan data) associated with one or more industrial plants utilizing an optimization model incorporating a model predictive control, such as an NMPC. In some embodiments, the optimization model generates optimal conceptual design(s) associated with one or more industrial plants based at least in part on input data with uncertainty quantification and associated with operation of the one or more industrial plants. Additionally, or alternatively, in some embodiments, the processor 202 includes hardware, software, firmware, and/or a combination thereof, that outputs the optimal conceptual design(s). Additionally, or alternatively, in some embodiments, the processor 202 includes hardware, software, firmware, and/or a combination thereof, that facilitates reconfiguration of the operation of at least one physical component based at least in part on the optimal conceptual design(s).

In some embodiments, the apparatus 200 includes input/output circuitry 206 that provides output to the user and, in some embodiments, to receive an indication of a user input. In some embodiments, the input/output circuitry 206 is in communication with the processor 202 to provide such functionality. The input/output circuitry 206 may comprise one or more user interface(s) and in some embodiments includes a display that comprises the interface(s) rendered as a web user interface, an application user interface, a user device, a backend system, or the like. In some embodiments, the input/output circuitry 206 also includes a keyboard, a mouse, a joystick, a touch screen, touch areas, soft keys a microphone, a speaker, or other input/output mechanisms. The processor 202 and/or input/output circuitry 206 comprising the processor may be configured to control one or more functions of one or more user interface elements through computer program instructions (e.g., software and/or firmware) stored on a memory accessible to the processor (e.g., memory 204, and/or the like). In some embodiments, the input/output circuitry 206 includes or utilizes a user-facing application to provide input/output functionality to a client device and/or other display associated with a user.

In some embodiments, the apparatus 200 includes communications circuitry 208. The communications circuitry 208 includes any means such as a device or circuitry embodied in either hardware or a combination of hardware and software that is configured to receive and/or transmit data from/to a network and/or any other device, circuitry, or module in communication with the apparatus 200. In this regard, in some embodiments the communications circuitry 208 includes, for example, a network interface for enabling communications with a wired or wireless communications network. Additionally, or alternatively in some embodiments, the communications circuitry 208 includes one or more network interface card(s), antenna(s), bus(es), switch(es), router(s), modem(s), and supporting hardware, firmware, and/or software, or any other device suitable for enabling communications via one or more communications network(s). Additionally, or alternatively, the communications circuitry 208 includes circuitry for interacting with the antenna(s) and/or other hardware or software to cause transmission of signals via the antenna(s) or to handle receipt of signals received via the antenna(s). In some embodiments, the communications circuitry 208 enables transmission to and/or receipt of data from user device, one or more asset(s) or accompanying sensor(s), and/or other external computing device in communication with the apparatus 200.

The model maintenance circuitry 212 includes hardware, software, firmware, and/or a combination thereof, that supports configuration and/or generation of one or more specially configured model(s) utilized to generate optimal conceptual design(s) for one or more industrial plants-such as optimal production process design for a particular industrial plant to achieve reduced emission (e.g., achieve net zero emission within a specified time horizon) and/or to ensure target demand are reliably and stably met. In some embodiments, the model maintenance circuitry 212 includes hardware, software, firmware, and/or a combination thereof, that performs one or more configuration operations and/or stores model configuration data with respect to the optimization model. In some embodiments, the model maintenance circuitry 212 includes hardware, software, firmware, and/or a combination thereof, that stores the optimization model. In some embodiments, the model maintenance circuitry 212 includes hardware, software, firmware, and/or a combination thereof, that updates the PIML model and/or optimization model. In some embodiments, the model maintenance circuitry 212 includes hardware, software, firmware, and/or a combination thereof, that stores historical power profile input data (e.g., past power profile input data) associated with a plant. In some embodiments, the model maintenance circuitry 212 includes hardware, software, firmware, and/or a combination thereof, that updates the optimization model. In some embodiments, the model maintenance circuitry 212 includes hardware, software, firmware, and/or a combination thereof, that receives or retrieves (e.g., from one or more databases) input data for the optimization model. In some embodiments, the model maintenance circuitry 212 includes a separate processor, specially configured field programmable gate array (FPGA), or a specially programmed application specific integrated circuit (ASIC).

The design circuitry 214 includes hardware, software, firmware, and/or a combination thereof, that supports generation of at least one optimal conceptual design (that accounts for intermittent and unsteady power supply) associated with operation of corresponding industrial plant(s)) utilizing at least one model (e.g., optimization model). In some embodiments, the design circuitry 214 utilizes data associated with one or more component(s) (e.g., physical components(s), assets, and/or the like) as input to the optimization model. In some embodiments, the design circuitry 214 includes hardware, software, firmware, and/or a combination thereof, that outputs the at least one optimal conceptual design. In some embodiments, the design circuitry 214 includes a separate processor, specially configured field programmable gate array (FPGA), or a specially programmed application specific integrated circuit (ASIC).

The optional control circuitry 216 includes hardware, software, firmware, and/or a combination thereof, that supports various functionality associated with causing configuration or causing other operation of at least one physical component of one or more industrial plants. For example, in some embodiments, the control circuitry 216 includes hardware, software, firmware, and/or a combination thereof, that facilitates and/or causes automatic reconfiguration of the operation of at least one physical component based at least in part on at least a portion of the optimal conceptual design. For example, in some embodiments, the control circuitry 216 includes hardware, software, firmware, and/or a combination thereof that configures and/or reconfigures (e.g., automatically configures and/or reconfigures) operation of at least one physical component (e.g., processing machine) of one or more industrial plants in accordance with the optimal conceptual design that accounts for uncertainty associated with operation of the one or more industrial plants. In some embodiments, the control circuitry 216 includes a separate processor, specially configured field programmable gate array (FPGA), or a specially programmed application specific integrated circuit (ASIC).

Additionally, or alternatively, in some embodiments, two or more of the sets of circuitries 202-208 and 212-216 are combinable. Alternatively, or additionally, in some embodiments, one or more of the sets of circuitry perform some or all of the functionality described associated with another component. For example, in some embodiments, two or more of the sets of circuitries 202-208 and 212-216 are combined into a single module embodied in hardware, software, firmware, and/or a combination thereof. Similarly, in some embodiments, one or more of the sets of circuitry, for example the model maintenance circuitry 212, design circuitry 214, and/or optional control circuitry 216, is/are combined with the processor 202, such that the processor 202 performs one or more of the operations described above with respect to each of these sets of circuitry 212-216.

EXAMPLE COMPUTER-IMPLEMENTED PROCESSES OF THE DISCLOSURE

Having described example systems, apparatuses, and data architectures in accordance with the present disclosure, example processes for generating optimal conceptual design and example processes for optimal site selection will now be discussed. In particular, example processes for generating optimal conceptual design for green hydrogen production processes and example processes for optimal renewable energy plant site selection will now be discussed. It will be appreciated that each of the flowcharts depicts an example computer-implemented process that is performable by one or more of the apparatuses, systems, devices, and/or computer program products described herein, for example utilizing one or more of the specially configured components thereof.

The blocks indicate operations of each process. Such operations may be performed in any of a number of ways, including, without limitation, in the order and manner as depicted and described herein. In some embodiments, one or more blocks of any of the processes described herein occur in between one or more blocks of another process, before one or more blocks of another process, in parallel with one or more blocks of another process, and/or as a sub-process of a second process. Additionally, or alternatively, any of the processes in various embodiments include some or all operational steps described and/or depicted, including one or more optional blocks in some embodiments. With regard to the flowcharts illustrated herein, one or more of the depicted block(s) in some embodiments is/are optional in some, or all, embodiments of the disclosure. Optional blocks are depicted with broken (or "dashed") lines. Similarly, it should be appreciated that one or more of the operations of each flowchart may be combinable, replaceable, and/or otherwise altered as described herein.

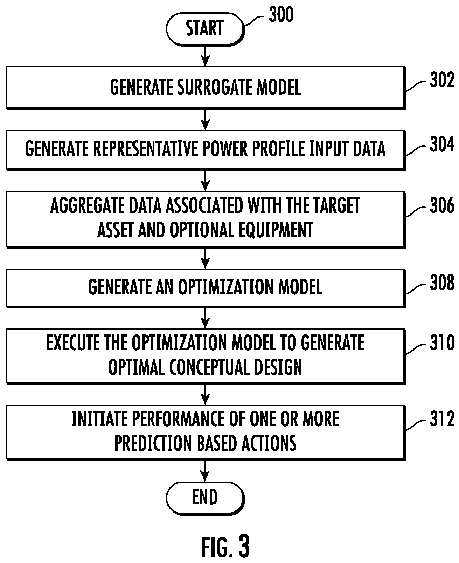

FIG. 3 illustrates an example of computer-implemented process 300 (e.g., conceptual design framework) for generating optimal conceptual design. In particular, FIG. 3 illustrates an example of computer-implemented process 300 for generating optimal conceptual design for green hydrogen production processes. The process 300 may be performed by the process design system 102 (described above with respect to FIG. 1).

In some embodiments, the process 300 is embodied by computer program code stored on a non-transitory computer-readable storage medium of a computer program product configured for execution to perform the process as depicted and described. Alternatively, or additionally, in some embodiments, the process 300 is performed by one or more specially configured computing devices, such as the apparatus 200 alone or in communication with one or more other component(s), device(s), system(s), and/or the like. In this regard, in some such embodiments, the apparatus 200 is specially configured by computer-coded instructions (e.g., computer program instructions) stored thereon, for example in the memory 204 and/or another component depicted and/or described herein and/or otherwise accessible to the apparatus 200, for performing the operations as depicted and described. For example, the apparatus 200 in some embodiments is in communication with separate physical component(s) of one or more industrial plants, and/or the like. For purposes of simplifying the description, the process 300 is described as performed by and from the perspective of the apparatus 200.

The conceptual design framework of FIG. 3 may be configured to optimize multiple variables and/or objectives. In an example embodiment, the conceptual design framework is configured to generate an optimal conceptual design for green hydrogen production processes that optimizes green hydrogen output of a hydrogen production plant while minimizing LCOH. For example, the optimal conceptual design framework may be configured to generate green hydrogen production process design that minimizes LCOH while meeting the hydrogen demand associated with the hydrogen production processing plant.

As further described below, generating such optimal conceptual design (e.g., that minimizes LCOH while ensuring the demand is met) may comprise optimizing a multi-period mixed integer dynamic optimization problem using a physics-informed machine learning-based surrogate process model (PIML-based surrogate process model).

In some embodiments, for green hydrogen production systems, a design metric for balancing total costs with total hydrogen produced over a long time horizon is LCOH. In various embodiments, the LCOH may be represented or otherwise defined as LCOH = Total Cost / Total Hydrogen Produced, where Total Cost is the sum of the capital cost and the discounted total operating cost (e.g., Total Cost = Capital Cost + Discounted Total Operating Cost).

The discounted operation cost may represent the total operating cost times a discount factor (.e.g., *Discounted Operating Cost = DiscountFactor \* Total Operating Cost)*. The discount factor may represent a value that converts future operating costs to current currency values and may be based on the discount rate. Existing LCOH definition of the design objective function does not include component indicating how well hydrogen production matches the target production rate. Accordingly, the objective to design to minimize LCOH is augmented with a primary objective to have minimal hydrogen demand imbalance as described herein.

In some embodiments, to determine a design to minimize LCOH a design to minimize the sum of the absolute values of the hydrogen imbalance over a future prediction horizon is determined (e.g.,

$$HydrogenAbsImbalance = \sum_{i=1}^{n_T} |HydrogenProducionRate - HydrogenProductionRateTarget|$$

). This ensures the hydrogen demand imbalance can be minimized before a design to minimize LCOH is performed so that could trade off cost for meeting the target hydrogen production. This design problem may not be executed manually with case studies, since changing the design to minimize LCOH cannot result in a new design that increases the hydrogen imbalance from the first design. This design problem formulation may be a hierarchical optimization problem and may be optimized/solved with an optimization-based strategy for this class of problems as described herein.

It will be appreciated that while example embodiments are described with respect to green hydrogen production processes, the optimal conceptual design framework described herein is not limited to the domain of green hydrogen production processes. The optimal conceptual design framework described herein may be used in various other domains.

The process 300 begins at operation 302. At operation 302, the apparatus 200 includes one or more circuitries (e.g., one or more of circuitries 202-216) that generates a PIML-based surrogate process model (referred to hereinafter as "surrogate process model") for a plant process. For example, the apparatus 200 may include one or more circuitries (e.g., one or more of circuitries 202-216) that configures and calibrates a surrogate process model.

In various embodiments, the input to at least a portion of the plant process comprises renewable energy input. For example, the input to one or more process equipment of the plant process may comprise renewable energy input (e.g., power from a renewable energy source) for operating the one or more process equipment. In particular, in some embodiments, the apparatus 200 includes one or more circuitries (e.g., one or more of circuitries 202-216) that generates a surrogate process model for a plant process, such as a green hydrogen production process whose primary power source for at least a portion of the green hydrogen production process comprises one or more renewable energy sources. A green hydrogen production process, for example, may include one or more electrolyzers and/or other process equipment whose primary power source comprises a renewable energy source. Non limiting examples of a renewable energy source include a solar power source and a wind power source.

In various embodiments, a green hydrogen production process includes a system of electrolyzer modules (e.g., comprising electrolyzers) that consume power to produce hydrogen from water, where the primary power source for supplying power to the electrolyzers and/or other process equipment associated with the plant process comprises solar power supplied by a solar power plant, wind power supplied by a wind power plant, and/or other renewable energy source including power purchases from renewable energy grid. Such process equipment whose primary power source comprises a renewable energy source may be referred to herein as a target asset with respect to generating optimal conceptual design for the plant process that includes such process equipment. It will be appreciated that the plant process is not limited to green hydrogen production process. The plant process can be any other green product process or non-green product process.

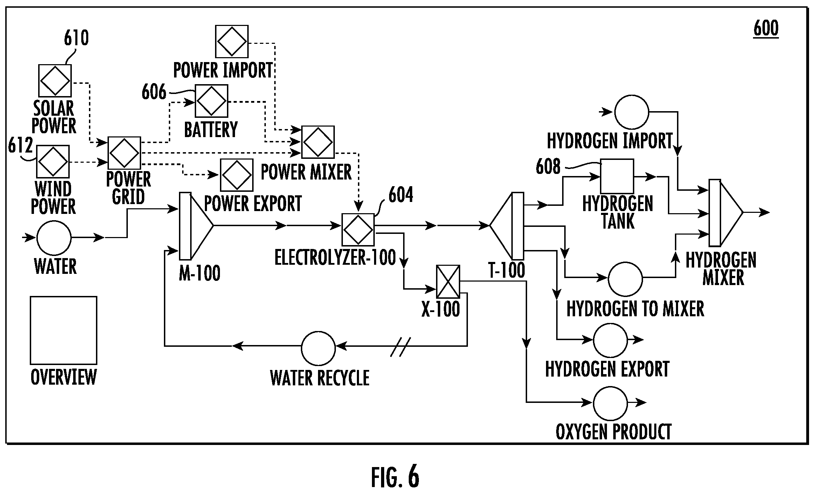

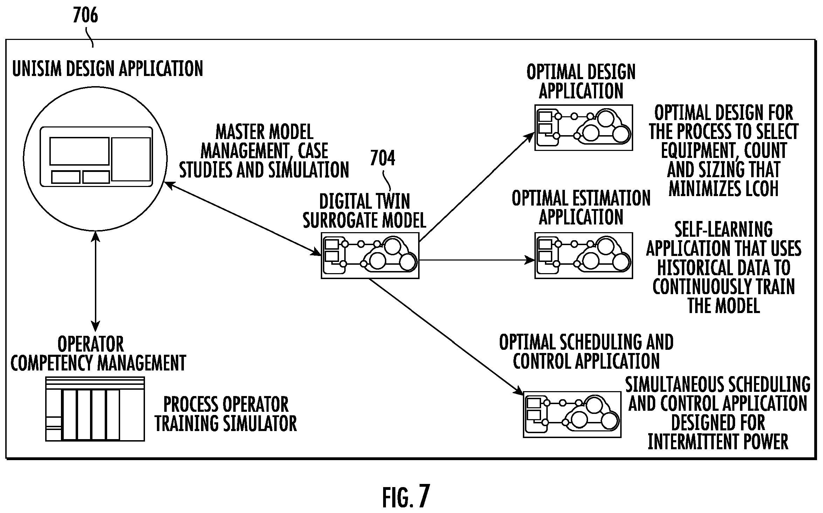

In various embodiments, the surrogate process model is a digital twin surrogate process model (such as the digital twin surrogate process model 704 shown in FIG. 7) generated based on a dynamic process model and physics-informed machine learning (PIML). A PIML is a machine learning approach that integrates physical laws and machine learning algorithms. In various embodiments, the dynamic process model is a rigorous process model in that the dynamic process model includes most or all of the known process variables, constraints, and/or mathematical equations such that the dynamic process model may be used to perform any of any of a plurality of simulation cases and/or optimize any of plurality of objective functions. In various embodiments, the dynamic process model comprises a flowsheet architecture. As shown in FIG. 6, the dynamic process model may comprise a flowsheet model (e.g., a base flowsheet model 600) that comprise a representation of various physical components (e.g., process equipment and/or the like) associated with a plant process and connections between the various connections. In particular, FIG. 6 illustrates a flowsheet model of a hydrogen production process. As shown in FIG. 6, the physical components modeled in the flowsheet may include one or more electrolyzers 604 and its associated auxiliary equipment packaged together, one or more batteries 606, one or more hydrogen storage tanks 608, one or more solar power sources 610, one or more wind power sources 612, and/or the like.

In various embodiments, the surrogate process model is a less complex but robust version of the dynamic process model. A surrogate process model, for example, may comprise fewer process variables, constraints, and/or mathematical equations relative to the dynamic process model. In various embodiments, the surrogate process model comprises a flowsheet architecture based on the flowsheet architecture of the dynamic process model from which the surrogate process model is derived. For example, the surrogate process model may comprise a surrogate flowsheet model based on a base flowsheet model, as described above.

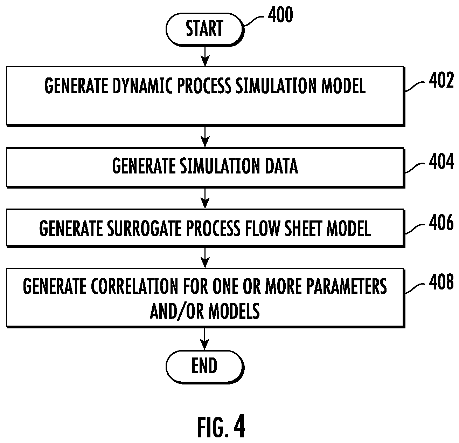

In some embodiments, the operation 302 is performed in accordance with the process 400 illustrated in FIG. 4, which is a process for generating a surrogate process model. The process 400 begins at operation 402.

At operation 402, the apparatus includes one or more circuitries (e.g., one or more of circuitries 202-216) that generates a dynamic process model. In various embodiments, the apparatus 200 generates the dynamic process model using a process simulation and modeling application or system, such as Honeywell's UniSim Design process simulation software/application 706 (shown in FIG. 7) or other applications configured for generating rigorous dynamic process models.

In various embodiments, the apparatus 200 may include such process simulation and modeling application or otherwise may be associated with such process simulation and modeling application. In various embodiments, the process simulation and modeling application is configured for performing mathematical modeling of a process and its unit operations from first principles. The process simulation and modeling application/system may be configured to perform steady-state and dynamic simulations that may be used by a process plant for optimization of various stages of the plant process lifecycle, including the conceptual design stage.

In various embodiments, as described above, the dynamic process model comprises a base flowsheet model of the process plant (e.g., plant process thereof) that includes a representation of the process plant including the process equipment (or portion of the process equipment) and relationships/connections between the process equipment. For example, the process simulation and modeling application/system may be configured to model a plant process (such as a hydrogen production process) and its unit operations and generate a flowsheet model of the plant process including the process equipment and connections between the process equipment.

In various embodiments, the dynamic process model comprises one or more target asset models, component slate, and/or thermodynamic variable parameters (e.g., thermodynamic options) such that accurate process simulation may be achieved. For example, the apparatus 200 using, a process simulation and modeling application/system, may be configured to generate a dynamic process model comprising target asset models, component slate, and/or thermodynamic variable parameters.

In various embodiments, the one or more target asset models comprise one or more electrolyzer models. In various embodiments, the component slate comprises one or more other physical components associated with the plant process. In various embodiments, the component slate comprises secondary power source(s), process output storage tanks, and/or other process equipment or physical components associated with the plant process. In various embodiments, for a hydrogen production process, the component slate may comprise at least secondary power source(s) for the system of electrolyzer modules (e.g., electrolyzer(s) thereof) and/or hydrogen storage tanks.

As described above, the primary power source for electrolyzers and/or other process equipment of a hydrogen production process may comprise solar power supplied by a solar power plant and/or wind power supplied by a wind power plant. In various embodiments, the power plant and/or wind plant may be co-located with process plant. The power output from such solar power plants and/or wind power plants may be intermittent and/or unsteady. For example, a power plant may not generate/output power during overnight hours. As another example, a wind power plant may not generate/output power when the wind velocity is below a certain threshold (e.g., about zero in some examples). Such intermittent and unsteady power supply to the electrolyzers and/or other process equipment may result in intermittent and/or unsteady process output (e.g., intermittent and/or unsteady hydrogen production), which in turn may lead to inability to meet the demand for such process output (e.g., hydrogen demand).

A secondary power source may be configured for supplying power to at least a portion of the plant process (e.g., one or more process equipment thereof) to mitigate against the effect of intermittent and/or unsteady power supply from the primary power source(s) that would otherwise be experienced. In various embodiments, a secondary power source comprises a power storage device such as, for example, a battery. The power storage device may be configured to store power and supply or otherwise provide the stored power to process equipment in response to loss of the primary power source (e.g., loss of power from the primary power source including intermittent and unsteady conditions associated therewith). In various embodiments, the power storage device may be configured to automatically supply the stored power to a process equipment in response to a primary power loss event (e.g., the occurrence of a primary power loss) or otherwise may be configured for being automatically triggered (e.g., by a system associated with the industrial plant) to supply the stored power in response to a primary power loss event.

At operation 404, the apparatus includes one or more circuitries (e.g., one or more circuitries 202-216) that generates simulation data using the dynamic process model. In various embodiments, to generate the simulation data, the apparatus 200 applies design of experiments (DOE) to the dynamic process model to create and/or execute one or more dynamic process simulation case runs. In some embodiments, applying DOE to the dynamic process model comprises applying the DOE to data generated from execution of one or more dynamic process simulation runs using the dynamic process model.

In various embodiments, the simulation data comprises thermodynamic fluid simulation data, process input simulation data, process output simulation data, and/or other simulation data that may be leveraged by an optimization model. In various embodiments, the process input simulation data and process output simulation data may be associated with the target asset(s) and comprise data associated with the input and output of the target asset(s).

In various embodiments, the process input simulation data for a hydrogen production process comprises power input data for electrolyzer(s) associated with the hydrogen production process, data about other inputs to the electrolyzers, and/or power input data for other components of the hydrogen production process that consume power supplied via a renewable energy source.

In various embodiments, the process output simulation data for a hydrogen production process comprises hydrogen production data, hydrogen crossover composition, electrolyzer voltages and/or the like, as function of the process inputs (e.g., power consumed by electrolyzer(s)). The simulation data, for example, may comprise one or more of thermodynamic fluid properties data, (ii) power input data for the one or more electrolyzers associated with the process with a particular topology or plant arrangement, or output data for the process as a function of the power input to the one or more electrolyzers.

At operation 406, the apparatus includes one or more circuitries (e.g., one or more of circuitries 202-216) that generate a surrogate flowsheet model. In various embodiments, the apparatus 200 generates the surrogate flowsheet model based on the simulation data and using one or more PIML models. In various embodiments, the surrogate flowsheet model is a representative surrogate flowsheet model (e.g., a generic surrogate flowsheet model) for the particular plant process domain. In particular, in various embodiments, the surrogate flowsheet model is configured to generate a surrogate model for a hydrogen production process that is representative of a green hydrogen production process topology.

At operation 408, the apparatus 200 includes one or more circuitries (e.g., one or more of circuitries 202-216) that generates, using the one or more PIML models, one or more process parameters and/or models and integrates the one or more process parameters and/or models into the surrogate flowsheet (e.g., incorporates the one or more process parameters and/or models into the surrogate flowsheet). The one or more process parameters and/or models may be based on the plant process domain. In various embodiments, for a hydrogen product process, the one or more process parameters and/or models comprise correlations for thermodynamic correction model(s), polarization (voltage vs current density) curves as a function of temperature and pressure, hydrogen crossover rates as a function of current density, power law correlation for compressor work and component split fractions as a function of temperature and pressure in separation vessels representing the purification equipment, and/or the like.

Returning to process 300 at operation 304, the apparatus 200 includes one or more circuitries (e.g., one or more of circuitries 202-216) that generates a representative power profile input data. In various embodiments, the representative power profile input data comprises or otherwise defines a predicted power input profile over a reduced time horizon relative to the process plant lifetime horizon. The process plant lifetime horizon, for example, may be 20-30 years with hourly optimization time periods (e.g., hourly optimization runs). In some examples. In various embodiments, the reduced time horizon is one year with hourly optimization time periods.

In this regard, the apparatus 200 may be configured to perform a time horizon reduction approximation operation to 8760, where the design optimization problem is condensed/reduced to a "8760" design optimization problem. In particular, such representative power profile input data enables generation of a condensed version of a multi-period integer dynamic optimization problem. Specifically, the power profile data may be aggregated using representative seasonal and diurnal data and extend over the full horizon by a degradation and discounted operating cost approximation. Alternatively, a technique that involves an option to include a typical day operation for each month and approximate the LCOH calculation by adjustment factors may be leveraged. It will be appreciated that in some other embodiments, the reduced time horizon may be greater than or less than one year.

In various embodiments, generating the representative power profile input data (e.g., by performing a time horizon reduction approximation operation may comprise aggregating the power profile input data for past years (e.g., past 5 years, 10 years, and/or the like). For example, in various embodiments, the apparatus 200 generates the representative power profile input data based on past power profile input data. The apparatus 200 may include one or more circuitries (e.g., one or more of circuitries 202-216) configured to aggregate past power profile input data for previous years (e.g., previous 5 years, 10 years, and/or the like) and average the aggregated past power profile input data to generate a representative power profile input data e.g., compress the aggregated into a N-year set of representative data, where N = 1, 2, or the like). In various embodiments, the past power profile input data includes, or otherwise reflects, seasonal and diurnal variations. In various embodiments, the past power profile input data are associated with the particular process plant with respect to which a conceptual design is being generated. Alternatively, or additionally, in some embodiments, the past power profile input data are associated with other process plant(s) similar to the particular process plant with respect to which a conceptual design is being generated.

At operation 306, the apparatus 200 includes one or more circuitries (e.g., one or more of circuitries 202-216) collecting, gathering, receiving, aggregating, and/or the like target asset input data and secondary asset input data. Non-limiting examples of such target asset input data include type cost, size of a given target asset. Non-limiting examples of such secondary asset input data include type cost, size of a given secondary asset. As described above, for a hydrogen production process, the target asset(s) may include electrolyzer(s) and the secondary asset(s) may include power storage device(s) and/or storage tank(s). In this regard, in various embodiments, non-limiting examples of target asset input data include type, size, and/or cost of a given electrolyzer. Further in various embodiments, non-liming examples of secondary asset input data include type, size, and/or cost of a given power storage device (e.g., a battery or the like), type, size, and/or cost of storage tanks (e.g., hydrogen storage tanks), secondary power source data (e.g., available solar power plants, location of available solar power plants, available wind power plants, location of available wind power plants, and/or the like). The power storage device(s) and/or storage tank(s) may be configured for building a buffer to mitigate against the effect of intermittent power supply from the renewable energy source.

At operation 308, the apparatus includes one or more circuitries (e.g., one or more of circuitries 202-216) that generates an optimization model (e.g., design optimization model). In various embodiments, generating the optimization model comprises configuring a design optimization problem corresponding to the optimization model. In various embodiments, the design optimization problem is specific to the plant process domain. In various embodiments, generating the optimization model comprises integrating the surrogate model into the optimization model along with an optimization algorithm representing the design algorithm.

In various embodiments, the design optimization problem is hydrogen production process design optimization problem, configured to optimize the design optimization problem such that an optimal conceptual design is generated for the corresponding hydrogen production plant (e.g., hydrogen production process thereof). The optimization model, for example, may comprise or otherwise reflect a hydrogen production process design optimization problem to be optimized by the optimization model to generate an optimal conceptual design for the hydrogen production process.

In various embodiments, the apparatus 200 configuring the design optimization problem comprises establishing and/or identifying the target process output demand, such as target hydrogen demand, and selecting optimization configuration parameters, such as time period (e.g., time period size) and time horizon (e.g., time horizon length).

The design optimization model (e.g., design optimization problem thereof) may comprise one or more optimization input parameters (e.g., optimization input data) and one or more decision variables. Table 1 below illustrates example input data for a design optimization problem with respect to a hydrogen production process.

**Table 1**

| Green Hydrogen Design Problem Input Data |
| --- |
| Solar Power Plant Available = {YES, NO} |
| Solar Power Plant Configuration Data |
| Wind Power Plant Available = {YES, NO} |
| Wind Power Plant Configuration Data |

(continued)

| Green Hydrogen Design Problem Input Data |
|---|
| Daily Target for Hydrogen Production |
| Set of Available Electrolyzer Types with sizes and price: $I = \{i: 1, ..., n_E^{types}\}$ |
| Set of Available Tank Types with sizes and price: : $J = \{j: 1, ..., n_T^{types}\}$ |
| Set of Available Battery Types with sizes and price: $K = \{k: 1, ..., n_B^{types}\}$ |
| Set of Locations for Green Hydrogen System = { Longitudes/Latitudes List } |
| Area Available for each Location and Price |
| Electricity Prices for Solar and Wind Power |
| Balance of Plant Equipment Cost Per KG hydrogen produced |

As illustrated in Table 1, in various embodiments, the optimization input data may include secondary power source data such as solar power plant availability data (e.g., data that describes whether a solar power plant is available to supply power) wind power plant availability data (e.g., data that describes whether a solar power plant is available to supply power), and/or other renewable energy plant availability data.

Alternatively, or additionally, in various embodiments, the optimization input data may include process output target data (e.g., daily target for hydrogen production). Alternatively, or additionally, in various embodiments, the optimization input data may include target asset data set comprising data that describes available target asset types and corresponding size and cost (e.g., set of available electrolyzer types and corresponding size and cost).

Alternatively, or additionally, various embodiments, the optimization input data may include one or more secondary asset datasets, each secondary asset dataset comprising data that describes available secondary asset types and corresponding size and cost for a respective secondary asset (e.g., set of available storage tank types and corresponding sizes and cost, set of available storage tank types and corresponding sizes and cost, and/or the like). Alternatively, or additionally, the input data for the design optimization model (e.g., design optimization problem thereof) includes secondary asset data set comprising data that describes available secondary asset types and corresponding size and cost (e.g., set of available storage tank types and corresponding sizes and cost).

Alternatively, or additionally, in various embodiments, the optimization input data may include process location data for the plant process (e.g., data that describes a set of locations for green hydrogen system, data that describes area available for each location and associated cost). Alternatively, or additionally, in various embodiments, the optimization input data may include renewable energy cost (e.g., solar power cost, wind power cost, and/or the like). Alternatively, or additionally, the Alternatively or additionally, in various embodiments, the optimization input data may include data that describes balance of plant equipment cost per unit of process (e.g., balance of plant equipment cost per kg of hydrogen produced).

At operation 310, the apparatus includes one or more circuitries (e.g., one or more of circuitries 202-216) that generates an optimal conceptual design based on the optimization model. For example, the apparatus 200 may include one or more circuitries (e.g., one or more of circuitries 202-216) that executes the optimization model to generate the optimal conceptual design for the process.

In various embodiments, the optimal conceptual design output comprises optimal value for one or more design decision variables. Table 2 below illustrates example decision design variables with respect to a hydrogen production process.

**Table 2**

| Green Hydrogen Design Decision Variables |
|---|
| Number of Electrolyzers of Type *i* |
| Number of Batteries of Type *j* |
| Number of Tanks of Type *k* |
| Location |
| Import Power(t) |
| Export Power(t) |

(continued)

| Green Hydrogen Design Decision Variables |
| --- |
| Power To Battery(t) |
| Power From Battery(t) |
| Import Hydrogen(t) |
| Export Hydrogen(t) |
| Hydrogen To Tank(t) |
| Hydrogen From Tank(t) |

As illustrated in Table 2, in various embodiments, the design decision variables may include number of target assets (e.g., electrolyzer) for a given asset type, number of power storage devices (e.g., battery) for a given power storage device type, number of process output storage tank (e.g., hydrogen storage tanks) for a given process output storage tank type. Alternatively, or additionally, in various embodiments, the design decision variables may include import power, export power, power to secondary power source, power from secondary power source, import process output, export process output, process output to process output storage tank, and/or process output from process output storage tank.

In particular, in various embodiments, the optimal conceptual design for a hydrogen product process may comprise optimal design data with respect to the target asset(s) and secondary asset(s). Such optimal data may include optimal number of target assets (e.g., optimal number of electrolyzers including type and size) optimal number of power storage devices (e.g., optimal number of batteries including type and size), optimal number of process output storage tanks (e.g., optimal number of hydrogen storage tanks including type and size), optimal topology for the process plant (e.g., including spatial location data that includes optimal location within the physical process plant to place each of the target asset(s) and secondary asset(s)).

In various embodiments, to optimize the design optimization problem and output optimal conceptual design, the optimization model executes a multi-stage design problem framework. In various embodiments, the first stage of the multi-stage design problem framework comprises minimizing the sum of absolute values of the process output imbalance values of the process output imbalance (e.g., minimize the sum of the hydrogen imbalance). In various embodiments, the second stage of the multi-stage design problem framework comprises minimizing the levelized cost of the process output (e.g., minimizing levelized cost of hydrogen). In various embodiments, executing the multi-stage design problem framework may comprise performing the operations in equation 1 (corresponding to the first stage of the multi-stage design problem framework) and equation 2 (corresponding to the second stage of the multi-stage design problem framework) below sequentially.

$$minimize \; \phi\_1 = x\_p$$

$$subject \; to$$

$$\mathbf{f}^\wedge min \leq \mathbf{f}(x) \leq \mathbf{f}^\wedge max$$

$$\mathbf{x}^\wedge min \leq \mathbf{x} \leq \mathbf{x}^\wedge max$$

**Equation 1**

$$minimize \; \phi\_2 = x\_q$$

$$subject \; to$$

$$\mathbf{f}^\wedge min \leq \mathbf{f}(x) \leq \mathbf{f}^\wedge max$$

$$\mathbf{x}^\wedge min \leq \mathbf{x} \leq \mathbf{x}^\wedge max$$

**Equation 2**

In the above equations, $x_p$ = hydrogen absolute imbalance sum, $\phi_1^* =$ minimum hydrogen absolute imbalance sum, $x_q$ = levelized cost of hydrogen, and $\phi_2^* =$ minimum levelized cost of hydrogen

In various embodiments, the decision problem output for a design optimization problem with respect to a hydrogen production process may include aggregate process output (e.g., total hydrogen production), power profile (e.g., solar Power profile, wind power profile), aggregate power available ( e.g., total power available, total power to the plant process), and/or process output imbalance (e.g., hydrogen imbalance). In some embodiments, the design problem output may further include one or more costs (e.g., capital cost, total operating cost, discounted total operating cost, levelized cost (e.g., LCOH), balance of plant design cost, and/or the like).

At operation 312, the apparatus includes one or more circuitries (e.g., one or more of circuitries 202-216) that initiates performance of one or more prediction-based actions. In some embodiments, the one or more prediction-based actions comprise causing rendering of the optimal conceptual design on a display of a client computing device such that, for example, the optimal conceptual design may be reviewed by a user associated with the client computing device. In some embodiments, the one or more prediction-based actions comprises providing the optimal conceptual design (e.g., optimal design data thereof) equipment sizes, topology to a system or application (such as Honeywell's UniSim Design) to support a digital thread, enabling a detailed design process to begin.

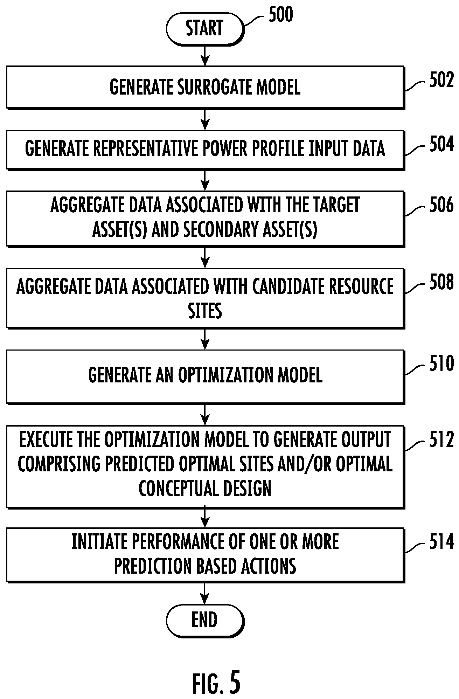

FIG. 5 illustrates an example of computer-implemented process 500 for optimal resource site selection. The resource site, for example, may be a renewable energy site. In particular, FIG. 5 illustrates an example of computer-implemented process 500 for optimal renewable energy plant site selection. In some embodiments, the process 500 is embodied by computer program code stored on a non-transitory computer-readable storage medium of a computer program product configured for execution to perform the process as depicted and described. Alternatively, or additionally, in some embodiments, the process 500 is performed by one or more specially configured computing devices, such as the apparatus 200 alone or in communication with one or more other component(s), device(s), system(s), and/or the like. In this regard, in some such embodiments, the apparatus 200 is specially configured by computer-coded instructions (e.g., computer program instructions) stored thereon, for example in the memory 204 and/or another component depicted and/or described herein and/or otherwise accessible to the apparatus 200, for performing the operations as depicted and described. For example, the apparatus 200 in some embodiments is in communication with separate physical component(s) of one or more industrial plants, and/or the like. For purposes of simplifying the description, the process 300 is described as performed by and from the perspective of the apparatus 200.

FIG. 5 provides a framework for simultaneous optimal renewable energy plant site location and optimal conceptual design for a green hydrogen production process (or other production process). In various embodiments, this includes generating an optimization model (e.g., design optimization problem thereof) configured for generating optimal conceptual design for a plant process (e.g., such as green hydrogen production process) in parallel with selecting optimal site location where the plant process will be co-located.

The process 500 begins at operation 502. At operation 502, the apparatus 200 includes one or more circuitries (e.g., one or more of circuitries 202-216) that generates a surrogate model in accordance with operation 302 described above with respect to FIG. 3. In this regard, operation 502 may be performed in accordance with process 400 described above with respect to FIG. 4.

At operation 504, the apparatus 200 includes one or more circuitries (e.g., one or more of circuitries 202-216) that generates representative power profile input data in accordance with the operation 304 described above with respect to FIG. 3.

At operation 506, the apparatus 200 includes one or more circuitries (e.g., one or more of circuitries 202-216) that collect, gather, receive, and/or aggregate target asset input data and secondary asset input data in accordance with the operation 306 described above with respect to FIG. 3.

At operation 508, the apparatus includes one or more circuitries (e.g., one or more of circuitries 202-216) that collect, gather, receive, and/or aggregate data associated with one or more resource sites (e.g., available renewable energy production sites such as available solar power plant and wind power plants) that can be considered as a co-location site with respect to the process plant. In various embodiments, such data includes site location data (e.g., longitude, latitude, site area, and/or the like) available for the green hydrogen production process, cost of grid connection, average cost of power for wind and solar at that site location, and solar and wind power carbon intensity. Site location, for example, may be impacted by irradiance characteristics in the solar power model for that location as well as capital and operating costs and site area available constraints.

At operation 510, the apparatus includes one or more circuitries (e.g., one or more of circuitries 202-216) that generates an optimization model (e.g., design optimization model) comprising a design optimization problem that includes site selection variables and constraints. For example, the design optimization problem may be a multi-design optimization problem (e.g., a multi-objective design optimization problem) in that it is configured for generating optimal conceptual design for a plant process as well as configured for predicting optimal site location where the plant process will be co-located. In various embodiments, as described above with respect to FIG. 3, in various embodiments, generating the optimization model comprises configuring a multi-design optimization problem for an optimization model.

In various embodiments, operation 510 may be performed in accordance with operation 308 above and in addition implementing (e.g., incorporating) site selection model variables and constraints into the design optimization problem. In various embodiments, implementing the site selection model variable(s) into the design optimization problem includes representing the site selection as a binary variable and introducing one variable for each candidate renewable energy site (e.g., each site under consideration). In various embodiments, the site selection model variable is represented as $z_j$ (0=NO, 1=YES), where the index $j$ represents the $j^{th}$ site.

In various embodiments, implementing the site selection constraint(s) into the optimization problem comprises adding the constraint Sum($z_j$) = 1 into the design optimization problem. Such site selection constraint variable (e.g., Sum($z_j$) = 1) may represent that only one site can be selected which enforces only one $z_j$ is equal to 1. In various embodiments implementing the site selection variable(s) and constraint(s) into the design optimization problem may further include augmenting the objective function for the design optimization problem with cost associated with respective sites (e.g., capital cost and/or operation cost) multiplied by the site selection variable $z_j$ such that cost associated with selected sites is considered in the design optimization problem with respect to generating an optimal conceptual design while non-selected sites have no impact.

Table 3 below illustrates example input data for a design optimization problem with respect to a hydrogen production process that includes site selection variable and constraints.

### Table 3

| Green Hydrogen Design Problem Input Data |
|---|
| Solar Power Plant Available = {*site_1*, *site_2*,...*site_j*,...*site_m*} |
| Solar Power Plant Configuration Data |
| Wind Power Plant Available = {*site_1*, *site_2*,... *site_j*,...*site_m*} |
| Wind Power Plant Configuration Data |
| Daily Target for Hydrogen Production |
| Set of Available Electrolyzer Types with sizes and price: $I = \{i\colon 1, \dots, n_E^{types}\}$ |
| Set of Available Tank Types with sizes and price: $J = \{j\colon 1, \dots, n_T^{types}\}$ |
| Set of Available Battery Types with sizes and price: $K = \{k\colon 1, \dots, n_B^{types}\}$ |
| Set of Locations for Green Hydrogen System = { Longitudes/Latitudes List } |
| Area Available for each Location and Price |
| Electricity Prices for Solar and Wind Power |
| Balance of Plant Equipment Cost Per KG hydrogen produced |

At operation 512, the apparatus includes one or more circuitries (e.g., one or more of circuitries 202-216) that initializes and/or activates the site selection optimization variables in the design optimization problem and executes the design optimization model to generate an output comprising the predicted optimal site(s) (e.g., optimal renewable energy plant site(s)) and/or the optimal conceptual design for the plant process.

At operation 514, the apparatus includes one or more circuitries (e.g., one or more of circuitries 202-216) that initiates performance of one or more prediction-based actions. In some embodiments, the one or more prediction-based actions comprise one or more of the prediction-based actions described above with respect to FIG. 3. Alternatively, or additionally, the one or more prediction-based actions comprises displaying or causing rendering of the predicted optimal site(s) (e.g., a representation of the prediction optimal site(s)) on a display of a client computing device.

Conclusion

Although an example processing system has been described above, implementations of the subject matter and the functional operations described herein can be implemented in other types of digital electronic circuitry, or in computer software, firmware, or hardware, including the structures disclosed in this specification and their structural equivalents, or in combinations of one or more of them.

Embodiments of the subject matter and the operations described herein can be implemented in digital electronic circuitry, or in computer software, firmware, or hardware, including the structures disclosed in this specification and their structural equivalents, or in combinations of one or more of them. Embodiments of the subject matter described herein can be implemented as one or more computer programs, i.e., one or more modules of computer program instructions, encoded on computer storage medium for execution by, or to control the operation of, information/data processing apparatus. Alternatively, or in addition, the program instructions can be encoded on an artificially-generated propagated signal, e.g., a machine-generated electrical, optical, or electromagnetic signal, which is generated to encode information/data for transmission to suitable receiver apparatus for execution by an information/data processing apparatus. A computer storage medium can be, or be included in, a computer-readable storage device, a computer-readable storage substrate, a random or serial access memory array or device, or a combination of one or more of them. Moreover, while a computer storage medium is not a propagated signal, a computer storage medium can be a source or destination of computer program instructions encoded in an artificially-generated propagated signal. The computer storage medium can also be, or be included in, one or more separate physical components or media (e.g., multiple CDs, disks, or other storage devices).

The operations described herein can be implemented as operations performed by an information/data processing apparatus on information/data stored on one or more computer-readable storage devices or received from other sources.

The term "data processing apparatus" encompasses all kinds of apparatus, devices, and machines for processing data, including by way of example a programmable processor, a computer, a system on a chip, or multiple ones, or combinations, of the foregoing. The apparatus can include special purpose logic circuitry, e.g., an FPGA (field programmable gate array) or an ASIC (application-specific integrated circuit). The apparatus can also include, in addition to hardware, code that creates an execution environment for the computer program in question, e.g., code that constitutes processor firmware, a protocol stack, a repository management system, an operating system, a cross-platform runtime environment, a virtual machine, or a combination of one or more of them. The apparatus and execution environment can realize various different computing model infrastructures, such as web services, distributed computing and grid computing infrastructures.

A computer program (also known as a program, software, software application, script, or code) can be written in any form of programming language, including compiled or interpreted languages, declarative or procedural languages, and it can be deployed in any form, including as a stand-alone program or as a module, component, subroutine, object, or other unit suitable for use in a computing environment. A computer program may, but need not, correspond to a file in a file system. A program can be stored in a portion of a file that holds other programs or information/data (e.g., one or more scripts stored in a markup language document), in a single file dedicated to the program in question, or in multiple coordinated files (e.g., files that store one or more modules, sub-programs, or portions of code). A computer program can be deployed to be executed on one computer or on multiple computers that are located at one site or distributed across multiple sites and interconnected by a communication network.

The processes and logic flows described herein can be performed by one or more programmable processors executing one or more computer programs to perform actions by operating on input information/data and generating output. Processors suitable for the execution of a computer program include, by way of example, both general and special purpose microprocessors, and any one or more processors of any kind of digital computer. Generally, a processor will receive instructions and information/data from a read-only memory or a random access memory or both. The essential elements of a computer are a processor for performing actions in accordance with instructions and one or more memory devices for storing instructions and data. Generally, a computer will also include or be operatively coupled to receive information/data from or transfer information/data to, or both, one or more mass storage devices for storing data, e.g., magnetic, magneto-optical disks, or optical disks. However, a computer need not have such devices. Devices suitable for storing computer program instructions and information/data include all forms of non-volatile memory, media and memory devices, including by way of example semiconductor memory devices, e.g., EPROM, EEPROM, and flash memory devices; magnetic disks, e.g., internal hard disks or removable disks; magneto-optical disks; and CD-ROM and DVD-ROM disks. The processor and the memory can be supplemented by, or incorporated in, special purpose logic circuitry.

To provide for interaction with a user, embodiments of the subject matter described herein can be implemented on a computer having a display device, e.g., a CRT (cathode ray tube) or LCD (liquid crystal display) monitor, for displaying information/data to the user and a keyboard and a pointing device, e.g., a mouse or a trackball, by which the user can provide input to the computer. Other kinds of devices can be used to provide for interaction with a user as well; for example, feedback provided to the user can be any form of sensory feedback, e.g., visual feedback, auditory feedback, or tactile feedback; and input from the user can be received in any form, including acoustic, speech, or tactile input. In addition, a computer can interact with a user by sending documents to and receiving documents from a device that is used by the user; for example, by sending web pages to a web browser on a user's client device in response to requests received from the web browser.

Embodiments of the subject matter described herein can be implemented in a computing system that includes a back-end component, e.g., as an information/data server, or that includes a middleware component, e.g., an application server, or that includes a front-end component, e.g., a client computer having a graphical user interface or a web browser through which a user can interact with an implementation of the subject matter described herein, or any combination of one or more such back-end, middleware, or front-end components. The components of the system can be interconnected by any form or medium of digital information/data communication, e.g., a communication network. Examples of communication networks include a local area network ("LAN") and a wide area network ("WAN"), an internetwork (e.g., the Internet), and peer-to-peer networks (e.g., ad hoc peer-to-peer networks).

The computing system can include clients and servers. A client and server are generally remote from each other and typically interact through a communication network. The relationship of client and server arises by virtue of computer programs running on the respective computers and having a client-server relationship with each other. In some embodiments, a server transmits information/data (e.g., an HTML page) to a client device (e.g., for purposes of displaying information/data to and receiving user input from a user interacting with the client device). Information/data generated at the client device (e.g., a result of the user interaction) can be received from the client device at the server.

While this specification contains many specific implementation details, these should not be construed as limitations on the scope of any disclosures or of what may be claimed, but rather as descriptions of features specific to particular embodiments of particular disclosures. Certain features that are described herein in the context of separate embodiments can also be implemented in combination in a single embodiment. Conversely, various features that are described in the context of a single embodiment can also be implemented in multiple embodiments separately or in any suitable subcombination. Moreover, although features may be described above as acting in certain combinations and even initially claimed as such, one or more features from a claimed combination can in some cases be excised from the combination, and the claimed combination may be directed to a subcombination or variation of a subcombination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single software product or packaged into multiple software products.

Thus, particular embodiments of the subject matter have been described. Other embodiments are within the scope of the following claims. In some cases, the actions recited in the claims can be performed in a different order and still achieve desirable results. In addition, the processes depicted in the accompanying figures do not necessarily require the particular order shown, or sequential order, to achieve desirable results. In certain implementations, multitasking and parallel processing may be advantageous.

**Claims**

1. A computer-implemented method for optimal site selection comprising:

   generating, by one or more processors and based on one or more physics-informed machine learning models and a rigorous dynamic process model, a surrogate process model, wherein the surrogate process model comprises a representation of a process including one or more target assets and one or more secondary assets, wherein process input for the one or more target assets comprises power output from a renewable energy source;
   generating, using the one or more processors, a design optimization algorithm representative of a multi-objective design optimization problem, wherein the design optimization algorithm comprises one or more site selection variables and one or more site selection constraints;
   generating, by the one or more processors, one or more outputs by executing an optimization model based on the surrogate process model and the design optimization algorithm, wherein the one or more outputs comprise predicted optimal sites and an optimal conceptual design for the process; and
   initiating, using the one or more processors, performance of one or more prediction-based actions based at least in part on the optimal conceptual design.

2. The computer-implemented method of claim 1, wherein generating the design optimization algorithm comprises representing the one or more site selection variables in the design optimization algorithm as a binary variable, and wherein the one or more site selection constraints comprises a constraint that enforces a sum of the one or more site selection variables to equal one.

3. The computer-implemented method of claim 1, further comprising:
   aggregating data associated with one or more candidate renewable energy sites.

4. The computer-implemented method of claim 3, wherein input data for the multi-objective design optimization problem comprises at least location data for each of the one or more candidate renewable energy sites.

5. The computer-implemented method of claim 3, wherein the one or more candidate renewable energy sites comprises one or more of a solar power plant or a wind power plant.

6. The computer-implemented method of claim 1, wherein generating the surrogate process model comprises:

generating one or more dynamic process simulation case runs based on the rigorous dynamic process model and design of experiments;
executing the one or more dynamic process simulation case runs to generate simulation data; and
generating a surrogate flowsheet model corresponding to the surrogate process model by applying the one or more physics-informed machine learning models to the simulation data.

7. The computer-implemented method of claim 5, wherein:

the process is a hydrogen production process configured for producing green hydrogen,
the one or more target assets comprise one or more electrolyzers, and
the one or more secondary assets comprise one or more power storage devices and one or more storage tanks, wherein the one or more power storage devices and the one or more storage tanks are configured for building a buffer to mitigate against effect of intermittent power supply from the renewable energy source.

8. The computer-implemented method of claim 6, wherein the optimal conceptual design comprises one or more of (i) optimal number of electrolyzers, (ii) optimal number of power storage devices, or (iii) optimal number of hydrogen storage tanks.

9. The computer-implemented method of claim 1, wherein initiating the performance of the one or more prediction-based actions comprises causing rendering of a user interface comprising the predicted optimal sites and the optimal conceptual design.

10. An apparatus for optimal site selection, the apparatus comprising at least one processor and at least one memory storing instructions that, when executed by the at least one processor, cause the apparatus to:

generate based on one or more physics-informed machine learning models and a rigorous dynamic process model, a surrogate process model, wherein the surrogate process model comprises a representation of a process including one or more target assets and one or more secondary assets, wherein process input for the one or more target assets comprises power output from a renewable energy source;
generate a design optimization algorithm representative of a multi-objective design optimization problem, wherein the design optimization algorithm comprises one or more site selection variables and one or more site selection constraints;
generate one or more outputs by executing an optimization model based on the surrogate process model and the design optimization algorithm, wherein the one or more outputs comprise predicted optimal sites and an optimal conceptual design for the process; and
initiate performance of one or more prediction-based actions based at least in part on the optimal conceptual design.

11. The apparatus of claim 10, wherein generating the design optimization algorithm comprises representing the one or more site selection variables in the design optimization algorithm as a binary variable, and wherein the one or more site selection constraints comprises a constraint that enforces a sum of the one or more site selection variables to equal one.

12. The apparatus of claim 10, wherein the apparatus is further caused to:
aggregate data associated with one or more candidate renewable energy sites.

13. The apparatus of claim 12, wherein input data for the multi-objective design optimization problem comprises at least location data for each of the one or more candidate renewable energy sites.

14. The apparatus of claim 12, wherein the one or more candidate renewable energy sites comprises one or more of a solar power plant or a wind power plant.

15. At least one non-transitory computer-readable storage medium for optimal site selection, the at least one non-

## EP 4 708 112 A1

transitory computer-readable storage medium having computer coded instructions configured to, when executed by at least one processor:

generate based on one or more physics-informed machine learning models and a rigorous dynamic process model, a surrogate process model, wherein the surrogate process model comprises a representation of a process including one or more target assets and one or more secondary assets, wherein process input for the one or more target assets comprises power output from a renewable energy source;

generate a design optimization algorithm representative of a multi-objective design optimization problem, wherein the design optimization algorithm comprises one or more site selection variables and one or more site selection constraints;

generate one or more outputs by executing an optimization model based on the surrogate process model and the design optimization algorithm, wherein the one or more outputs comprise predicted optimal sites and an optimal conceptual design for the process; and

initiate performance of one or more prediction-based actions based at least in part on the optimal conceptual design.

EP 4 708 112 A1

FIG. 1

200

MEMORY
204

MODEL
MAINTENANCE
CIRCUITRY 212

DESIGN
CIRCUITRY
214

PROCESSOR
202

INPUT/OUTPUT
CIRCUITRY
206

CONTROL
CIRCUITRY
216

COMMUNICATIONS
CIRCUITRY
208

FIG. 2

START — 300

GENERATE SURROGATE MODEL — 302

GENERATE REPRESENTATIVE POWER PROFILE INPUT DATA — 304

AGGREGATE DATA ASSOCIATED WITH THE TARGET ASSET AND OPTIONAL EQUIPMENT — 306

GENERATE AN OPTIMIZATION MODEL — 308

EXECUTE THE OPTIMIZATION MODEL TO GENERATE OPTIMAL CONCEPTUAL DESIGN — 310

INITIATE PERFORMANCE OF ONE OR MORE PREDICTION BASED ACTIONS — 312

END

FIG. 3

START — 400

GENERATE DYNAMIC PROCESS SIMULATION MODEL — 402

GENERATE SIMULATION DATA — 404

GENERATE SURROGATE PROCESS FLOW SHEET MODEL — 406

GENERATE CORRELATION FOR ONE OR MORE PARAMETERS AND/OR MODELS — 408

END

FIG. 4

START — 500

GENERATE SURROGATE MODEL — 502

GENERATE REPRESENTATIVE POWER PROFILE INPUT DATA — 504

AGGREGATE DATA ASSOCIATED WITH THE TARGET ASSET(S) AND SECONDARY ASSET(S) — 506

AGGREGATE DATA ASSOCIATED WITH CANDIDATE RESOURCE SITES — 508

GENERATE AN OPTIMIZATION MODEL — 510

EXECUTE THE OPTIMIZATION MODEL TO GENERATE OUTPUT COMPRISING PREDICTED OPTIMAL SITES AND/OR OPTIMAL CONCEPTUAL DESIGN — 512

INITIATE PERFORMANCE OF ONE OR MORE PREDICTION BASED ACTIONS — 514

END

FIG. 5

FIG. 6

FIG. 7

EP 4 708 112 A1

# EUROPEAN SEARCH REPORT

Europäisches
Patentamt
European
Patent Office
Office européen
des brevets

**Application Number**

EP 25 19 9677

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | PRINA MATTEO GIACOMO ET AL: "Machine learning as a surrogate model for EnergyPLAN: Speeding up energy system optimization at the country level", ENERGY, ELSEVIER, AMSTERDAM, NL, vol. 307, 3 August 2024 (2024-08-03), XP087591383, ISSN: 0360-5442, DOI: 10.1016/J.ENERGY.2024.132735 [retrieved on 2024-08-03] * paragraph [0001] - paragraph [0003] * ----- | 1-15 | INV. G06F30/20 G06F30/27 G06N20/00 G06Q10/04 |
| X | KOLLURI RAMACHANDRA RAO RKOLLURI@AU1 IBM COM ET AL: "Adaptive Control Using Machine Learning for Distributed Storage in Microgrids", PROCEEDINGS OF THE ELEVENTH ACM INTERNATIONAL CONFERENCE ON FUTURE ENERGY SYSTEMS, ACMPUB27, NEW YORK, NY, USA, 12 June 2020 (2020-06-12), pages 509-515, XP058452033, DOI: 10.1145/3396851.3402122 ISBN: 978-1-4503-8009-6 * paragraph [0001] - paragraph [0004] * ----- | 1-15 | |
| X | ABID HOSSAIN KHAN ET AL: "Digital Twin and Artificial Intelligence Incorporated With Surrogate Modeling for Hybrid and Sustainable Energy Systems", ARXIV.ORG, CORNELL UNIVERSITY LIBRARY, 201 OLIN LIBRARY CORNELL UNIVERSITY ITHACA, NY 14853, 30 September 2022 (2022-09-30), XP091331121, * paragraph [0001] - paragraph [0005] * ----- | 1-15 | TECHNICAL FIELDS SEARCHED (IPC) G06F G06E G06Q G06N |

The present search report has been drawn up for all claims

| Place of search | Date of completion of the search | Examiner |
|---|---|---|
| Munich | 22 January 2026 | Bec, Thierry |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P4C01)